# EUROPÄISCHE PATENTSCHRIFT

(11) **EP 2 683 035 B1**
(45) Veröffentlichungstag und Bekanntmachung des Hinweises auf die Patenterteilung: **04.09.2019**
(21) Anmeldenummer: 13174631.5
(22) Anmeldetag: 02.07.2013
(51) Int. Cl.: H01R 12/52, H01R 12/57, H01R 12/91, H01R 43/02, G01D 5/14, H05K 3/36, G01D 11/24

(54) **Platine, Stellvorrichtung und Herstellungsverfahren**
Circuit board, actuating device, and method of manufacturing
Platine, dispositif de réglage, et procédé de fabrication

(30) Priorität: 03.07.2012 DE 102012211536
(43) Veröffentlichungstag der Anmeldung: 08.01.2014
(73) Patentinhaber: MAHLE International GmbH, 70376 Stuttgart (DE)
(72) Erfinder: Nestmann, Bernhard, 70563 Stuttgart (DE); Weber, Stephan, 70469 Stuttgart (DE)
(74) Vertreter: BRP Renaud & Partner mbB Rechtsanwälte Patentanwälte Steuerberater

(56) Entgegenhaltungen:
- EP-A2- 2 463 962
- WO-A1-03/053115
- DE-A1-102009 035 091
- US-A- 4 159 505
- US-A- 4 702 708
- US-A- 4 775 917
- US-A- 5 451 174
- US-A1- 2010 007 228
- US-B1- 7 494 389

## Beschreibung

Die vorliegende Erfindung betrifft eine Platine mit den Merkmalen von Anspruch 1, sowie eine Stellvorrichtung zum bidirektionalen Verstellen eines Stellglieds mit einer solchen Platine und ein Verfahren zum Herstellen einer solchen Platine.

Aus der EP 2 463 962 A2 ist ein gattungsgemäßes Kontaktelement bekannt, das einen Stift, eine Drahtaufnahme und eine Federzone aufweist, die den Stift mit der Drahtaufnahme federelastisch verbindet. Die Federzone weist zwei L-förmige Bogenabschnitte, zwei U-förmige Bogenabschnitte und drei Querabschnitte auf. Aus der DE 10 2009 035 091 A1 ist eine Stellvorrichtung zum bidirektionalen Verstellen eines Stellglieds bekannt, die ein Gehäuse aus Kunststoff sowie einen am Gehäuse angeordneten Stellantrieb zum Erzeugen von Stellkräften aufweist. Ferner ist eine mit dem Stellantrieb antriebsverbundene und mit dem Stellglied antriebsverbindbare Kopplungseinrichtung zum Übertragen der Stellkräfte vom Stellantrieb auf das Stellglied vorgesehen. Ferner weist eine derartige Stellvorrichtung eine Positionssensorik zum Erfassen einer Position einer mobilen Komponente der Stellvorrichtung relativ zu einer stationären Komponente der Stellvorrichtung auf, wodurch die Stellvorrichtung stets die aktuelle Position des Stellglieds kennt. Die Positionssensorik ist dabei mit einer Platine ausgestattet, die zumindest einen Positionssensor, vorzugsweise ein Hall-Sensor, trägt und die mit einer Metallstruktur elektrisch kontaktiert ist, die zumindest teilweise in den Kunststoff des Gehäuses eingebettet ist.

Stellvorrichtungen dieser Art können beispielsweise bei Brennkraftmaschinen von Kraftfahrzeugen zur Anwendung kommen, um Stellglieder zu betätigen. Stellglieder, die hierzu in Frage kommen, sind beispielsweise eine Drosselklappe, Steuerklappen einer Frischluftanlage, wie zum Beispiel Tumbleklappen oder Drallklappen, ein Wastegate-Ventil eines Abgasturboladers, eine variable Turbinengeometrie eines Abgasturboladers sowie ein Abgasrückführventil einer Abgasrückführanlage. Bei derartigen Fahrzeuganwendungen ist die jeweilige Stellvorrichtung vergleichsweise großen Temperaturschwankungen ausgesetzt, wodurch sich thermische Ausdehnungseffekte bemerkbar machen. Dabei hat sich gezeigt, dass die elektrische Kontaktierung zwischen der Platine, die üblicherweise aus einem Kunststoffmaterial hergestellt ist, wie zum Beispiel ein Basislaminat der Flammschutzklasse 4, FR4, und der Metallstruktur besonders anfällig ist für thermisch bedingte Spannungen und die damit einhergehenden Lastwechsel.

Die vorliegende Erfindung beschäftigt sich mit dem Problem, für eine Stellvorrichtung der eingangs genannten Art bzw. für eine hierfür geeignete Platine eine verbesserte Ausführungsform bzw. verbesserte elektrische / mechanische Anbindung anzugeben, die sich insbesondere durch eine verbesserte thermische Stabilität auszeichnet.

Erfindungsgemäß wird dieses Problem durch die Gegenstände der unabhängigen Ansprüche gelöst. Vorteilhafte Ausführungsformen sind Gegenstand der abhängigen Ansprüche.

Die Erfindung beruht auf dem allgemeinen Gedanken, die Platine mit wenigstens einem Kontaktelement auszustatten, mit dessen Hilfe im Einbauzustand die elektrische Kontaktierung zwischen der Platine und der Metallstruktur hergestellt werden kann. Das jeweilige Kontaktelement weist dabei eine Platinenkontaktzone, die mit der Platine elektrisch kontaktiert ist, eine Metallstrukturkontaktzone, die im eingebauten Zustand mit der Metallstruktur elektrisch kontaktiert ist, sowie eine Federzone auf, die zwischen der Platinenkontaktzone und der Metallstrukturkontaktzone angeordnet ist, die, insbesondere wellenförmig und/oder spiralförmig, gebogen ist und die Relativbewegungen zwischen der Platinenkontaktzone und der Metallstrukturkontaktzone federelastisch aufnimmt. Durch die Verwendung eines derartigen Kontaktelements können thermisch bedingte Relativbewegungen zwischen der Platine und der Metallstruktur innerhalb der Federzone des jeweiligen Kontaktelements federelastisch kompensiert werden, wodurch die mechanische Belastung der elektrischen Kontakte in der Platinenkontaktzone und in der Metallstrukturkontaktzone signifikant reduziert wird. Da die jeweilige Federzone durch die federelastischen Deformationen nur in ihrem elastischen Bereich belastet wird, sind sämtliche üblicherweise auftretenden Verformungen reversibel, so dass quasi beliebig viele Lastwechsel bzw. Temperaturwechsel auftreten können, ohne dass dabei unzulässig hohe mechanische Belastungen an den Kontaktzonen auftreten. Die Dauerhaltbarkeit der elektrischen Kontaktierung zwischen Platine und Metallstruktur und somit der gesamten Stellvorrichtung kann dadurch erheblich verbessert werden.

Erfindungsgemäß erstrecken sich die Platinenkontaktzone und die Metallstrukturkontaktzone jeweils geradlinig und parallel zueinander, während die Federzone zumindest zwei Querabschnitte aufweist, wobei sich der jeweilige Querabschnitt quer zur Platinenkontaktzone und somit auch quer zur Metallstrukturkontaktzone erstreckt. Der jeweilige Querabschnitt wird bei Relativbewegungen zwischen Platine und Metallstruktur, die parallel zu den Kontaktzonen orientiert sind, nur auf Biegung belastet, wodurch besonders große federelastische Stellwege realisierbar sind, ohne dass es zu einer plastischen Deformation der Federzone kommt.

Besonders vorteilhaft ist eine Ausführungsform, bei welcher die Federzone drei Wendepunkte in ihrem gebogenen Verlauf enthält. Bevorzugt ist dabei eine Variante, bei welcher die Federzone genau drei Wendepunkte in ihrem gebogenen Verlauf enthält. Bei drei Wendepunkten lässt sich eine besonders kompakte Federzone realisieren, die vergleichsweise große federelastische Stellwege zwischen den Kontaktzonen ermöglicht.

Erfindungsgemäß weist die Federzone einen ersten Querabschnitt auf, der über einen ersten L-förmigen Bogenabschnitt in die Platinenkontaktzone übergeht und der über einen ersten U-förmigen Bogenabschnitt in einen zweiten Querabschnitt übergeht, der seinerseits über einen zweiten U-förmigen Bogenabschnitt in einen dritten Querabschnitt übergeht, der seinerseits über einen zweiten L-förmigen Bogenabschnitt in die Metallstrukturkontaktzone übergeht. Die Bogenabschnitte können dabei ähnliche, vorzugsweise gleiche, Biegeradien aufweisen. Die L-förmigen Bogenabschnitte entsprechen dann einem 90°-Bogen, während die U-förmigen Bogenabschnitte dann einem 180°-Bogen entsprechen. Durch die Bogenabschnitte lassen sich vergleichsweise große elastische Stellwege in der Längsrichtung des Kontaktelements also quer zu den Querabschnitten und parallel zu den Kontaktzonen realisieren.

Erfindungsgemäß ist die Metallstrukturkontaktzone bezüglich einer Querrichtung des Kontaktelements zwischen dem ersten U-Bogen und dem zweiten U-Bogen positioniert. Hierdurch lässt sich ein in der Querrichtung des Kontaktelements gemessener Abstand zwischen der Platine und der Metallstruktur reduzieren.

Gemäß einer anderen vorteilhaften Weiterbildung kann der zweite U-Bogen bezüglich einer Querrichtung des Kontaktelements zwischen der Platinenkontaktzone und der Metallstrukturkontaktzone positioniert sein. Durch diese Formgebung kann sich die Platine bis in die Federzone hineinerstrecken, ohne dass die Gefahr eines Kontakts zwischen der Platine und der Federzone entsteht. Ein derartiger Überstand der Platine gegenüber der Federzone kann dann erforderlich sein, wenn eine platinenseitige Kontaktfläche, die zur elektrischen Kontaktierung mit der Platinenkontaktzone vorgesehen ist, einen vergleichsweise großen Abstand zu einem Rand der Platine besitzt.

Sofern eine an der Metallstruktur ausgebildete Kontaktfläche, die zur elektrischen Kontaktierung mit der Metallstrukturkontaktzone vorgesehen ist, an der Metallstruktur randseitig angeordnet ist, kann der erste U-Bogen bezüglich einer Querrichtung des Kontaktelements über die Metallstrukturkontaktzone vorstehen und dementsprechend den Rand der Metallstruktur in besagte Querrichtung überlappen. Zweckmäßig können sich die Querabschnitte geradlinig und parallel zueinander erstrecken. Vorzugsweise erstrecken sich die Querabschnitte dabei senkrecht zu den Kontaktzonen, die sich ihrerseits geradlinig und parallel zueinander erstrecken.

Entsprechend einer besonders vorteilhaften Ausführungsform kann die Platine für das jeweilige Kontaktelement eine Kontaktfläche zur elektrischen Kontaktierung mit dem Kontaktelement aufweisen. Beispielsweise kann eine derartige Kontaktfläche durch eine elektrisch leitende, vorzugsweise metallische, Beschichtung der Platine realisieren werden. Ferner kann das jeweilige Kontaktelement mit dazugehöriger Kontaktfläche stoffschlüssig verbunden sein. Eine stoffschlüssige Verbindung lässt sich beispielsweise in Form einer Schweißverbindung oder Lötverbindung realisieren. Darüber hinaus kann das jeweilige Kontaktelement zusätzlich zur stoffschlüssigen Verbindung mit einer Klebverbindung an der Platine befestigt sein. Die Verwendung einer Klebverbindung vereinfacht die Herstellung der Platine bzw. die Bestückung der Platinen mit den Kontaktelementen, was weiter unten mit Bezug auf das Herstellungsverfahren noch näher erläutert wird.

Entsprechend einer vorteilhaften Weiterbildung kann in der jeweiligen Kontaktfläche, vorzugsweise randseitig, in einem vom jeweiligen Kontaktelement abgedeckten Kontaktbereich eine Klebestelle ausgespart sein, in der die Klebverbindung ausgebildet ist. Durch die Aussparung der Klebestelle im Kontaktbereich der Kontaktfläche kann die Klebverbindung unmittelbar zwischen dem Kontaktelement und der Platine realisiert werden. Hierdurch erfolgt die Verklebung des Kontaktelements nicht mit der die Kontaktfläche bildenden elektrisch leitenden Beschichtung, sondern direkt mit der Platine. Hierdurch kann beispielsweise die Gefahr einer Beschädigung der Kontaktfläche, die in der Regel durch eine sehr dünne Beschichtung realisiert ist, durch den Klebstoff vermieden werden.

Besonders vorteilhaft ist dabei eine Weiterbildung, bei welcher die jeweilige Klebestelle eine mit dem Klebstoff versehene, insbesondere kreisförmige und zentrale, Klebstoffzone sowie eine klebstofffreie, insbesondere ringförmige und die Klebstoffzone umschließende, Abstandszone aufweist. Hierdurch ist sichergestellt, dass der Klebstoff die Kontaktfläche nicht berühren und sich nicht mit dieser vermischen kann.

Gemäß einer weiteren Ausgestaltung können zusätzliche Anker an dem Kontaktelement vorgesehen sein, welche in Aussparungen an der Platine eingreifen, um die mechanische Stabilität zu verbessern. Optional kann der jeweilige Anker auch mit der Platine, z.B. im Bereich der Kontaktfläche, verlötet sein, um zusätzliche Stabilität zu erreichen. In diesem Fall handelt es sich um einen Lötanker.

Ein erfindungsgemäßes Verfahren zum Herstellen der Platine, die sich insbesondere für eine Stellvorrichtung der vorstehend beschriebenen Art eignet, charakterisiert sich dadurch, dass wenigstens eine elektrisch leitende, insbesondere metallische, Kontaktfläche, die an der jeweiligen Platine zur elektrischen Kontaktierung mit dem Kontaktelement vorgesehen ist, mit einer Lotpaste bedruckt wird. Ferner wird neben dem mit der Lotpaste bedruckten Lotbereich wenigstens ein Klebstoff unmittelbar auf die Platine aufgebracht. Das Aufbringen des Klebstoffs kann dabei vor oder nach dem Aufdrucken der Lotpaste oder gleichzeitig mit dem Aufdrucken der Lotpaste realisiert werden. Anschließend erfolgt die Bestückung der Platine mit dem jeweiligen Kontaktelement, wobei das jeweilige Kontaktelement auf die Platine derart aufgebracht wird, dass das jeweilige Kontaktelement zum einen mit dem Lotbereich flächig kontaktiert ist und zum anderen mittels des Klebstoffs hinreichend fest mit der Platine verbunden ist. Auf diese Weise ist das jeweilige Kontaktelement relativ zur Platine in einer zwischen Kontaktelement und Platine vorgesehenen Position fixiert. Zu einem späteren Zeitpunkt kann dann das Kontaktelement mit der Kontaktfläche mittels der Lotpaste verlötet werden. Die Verwendung der Klebverbindung ermöglicht es, den Zeitpunkt des Lötprozesses zu verschieben, da die beim Bestücken der Platine zwischen Platine und Kontaktelement erzeugte Relativlage mit Hilfe des Klebstoffs fixiert. Hierdurch lässt sich insbesondere auch ein Transport zwischen einer Bestückungsstation und einer Lötstation einfach realisieren, da die Kontaktelemente mit Hilfe des Klebstoffs hinreichend an der Platine fixiert sind. Insbesondere können sich hierdurch auch engere Lagetoleranzen für die Kontaktelemente auf der Platine realisieren. Der Klebstoff kann dabei ein dauerelastischer Klebstoff sein. Ebenso ist denkbar, einen Klebstoff zu verwenden, der aushärtet oder austrocknet. Bei der Verwendung eines Klebstoffs, der aushärtet bzw. austrocknet, erfolgt die Bestückung mit den Kontaktelementen bevor der Klebstoff ausgehärtet bzw. ausgetrocknet ist.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch
- Fig. 1: eine stark vereinfachte, teilweise geschnittene Prinzipdarstellung einer Stellvorrichtung,
- Fig. 2: eine isometrische Ansicht eines Details II aus Fig. 1 im Bereich eines Kontaktelements,
- Fig. 3: eine Draufsicht auf eine Platine vor ihrer Bestückung,
- Fig. 4: eine Draufsicht der Platine nach ihrer Bestückung,
- Fig. 5: eine isometrische Ansicht wie in Fig. 2, jedoch in einer anderen Blickrichtung.

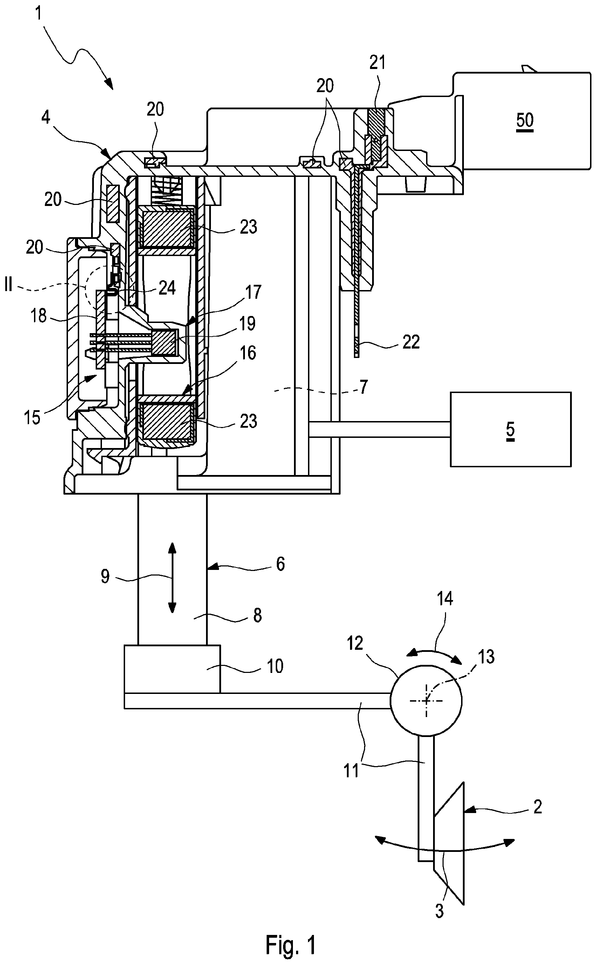

Entsprechend Figur 1 umfasst eine Stellvorrichtung 1, mit deren Hilfe ein Stellglied 2 entsprechend einem Doppelpfeil 3 bidirektional verstellbar ist, ein Gehäuse 4, das aus einem Kunststoff hergestellt ist, einen Stellantrieb 5 zum Erzeugen von Stellkräften sowie eine Kopplungseinrichtung 6 zum Übertragen der Stellkräfte vom Stellantrieb 5 auf das Stellglied 2. Die Kopplungseinrichtung 6 ist hierzu auf geeignete Weise einerseits mit dem Stellantrieb 5 und andererseits mit dem Stellglied 2 antriebsverbunden. Beispielsweise kann die Kopplungseinrichtung 6 hierzu in einem Getrieberaum 7 des Gehäuses 4 ein hier nicht erkennbares Getriebe aufweisen, das eine Drehbewegung des beispielsweise als Elektromotor ausgestalteten Stellantriebs 5 in eine Linearbewegung einer Stange 8 übersetzt, wodurch diese entsprechend einem Doppelpfeil 9 bidirektional verstellbar ist. Die Stange 8 kann über ein Gelenk 10 mit einer Hebelanordnung 11 mit dem Stellglied 2 verbunden sein. Die Hebelanordnung 11 kann dabei eine Spindel 12 umfassen, die um eine Schwenkachse 13 gemäß einem Doppelpfeil 14 bidirektional verstellbar ist, wodurch sich letztlich auch die bidirektionale Verstellbarkeit des Stellglieds 2 um besagte Schwenkachse 13 ergibt. Beispielsweise kann es sich beim Stellglied 2 um ein Wastegate-Ventil eines im Übrigen hier nicht gezeigten Abgasturboladers handeln.

Die Stellvorrichtung 1 weist außerdem eine Positionssensorik 15 auf, mit deren Hilfe eine Position einer mobilen Komponente 16 der Stellvorrichtung 1 relativ zu einer stationären Komponente 17 der Stellvorrichtung 1 erfasst werden kann. Die Positionssensorik 15 besitzt hierzu eine Platine 18, an der zumindest ein Positionssensor 19 befestigt ist und die mit einer Metallstruktur 20 elektrisch kontaktiert ist. Die Metallstruktur 20, die beispielsweise ein Stanzgitter sein kann, ist dabei zumindest teilweise in den Kunststoff des Gehäuses 4 eingebettet. Im Beispiel ist die Metallstruktur 20 distal zur Platine 18 mit elektrischen Kontakten 21, 22 ausgestattet, über welche die Stellvorrichtung 1 beispielsweise an eine elektrische Stromversorgung (nicht gezeigt) angeschlossen werden kann und über welche Positionssignale, die mit Hilfe der Positionssensorik 15 generiert werden, an eine entsprechende Steuerung (nicht gezeigt) weitergeleitet werden können. Außerdem ist hier noch eine weitere elektrische Schnittstelle 50 vorgesehen, über die Daten und/oder Signale zwischen der Stellvorrichtung 1 und einer hier nicht gezeigten Peripherie übertragbar sind. Beispielsweise kann die Stellvorrichtung 1 in ein Netzwerk bzw. Bussystem eingebunden sein.

Der Positionssensor 19 kann beispielsweise ein Hall-Sensor, eine Lichtschranke oder ein optisches Messsystem sein und in die stationäre Komponente 17 hineinragen. Die mobile Komponente 16 kann mit wenigstens einem Permanentmagneten 23 ausgestattet sein, um ein Magnetfeld zu erzeugen, das sich bei einer Relativbewegung zwischen der mobilen Komponente 16 und der stationären Komponente 17 verändert, was wiederum vom Positionssensor 19 erfasst werden kann.

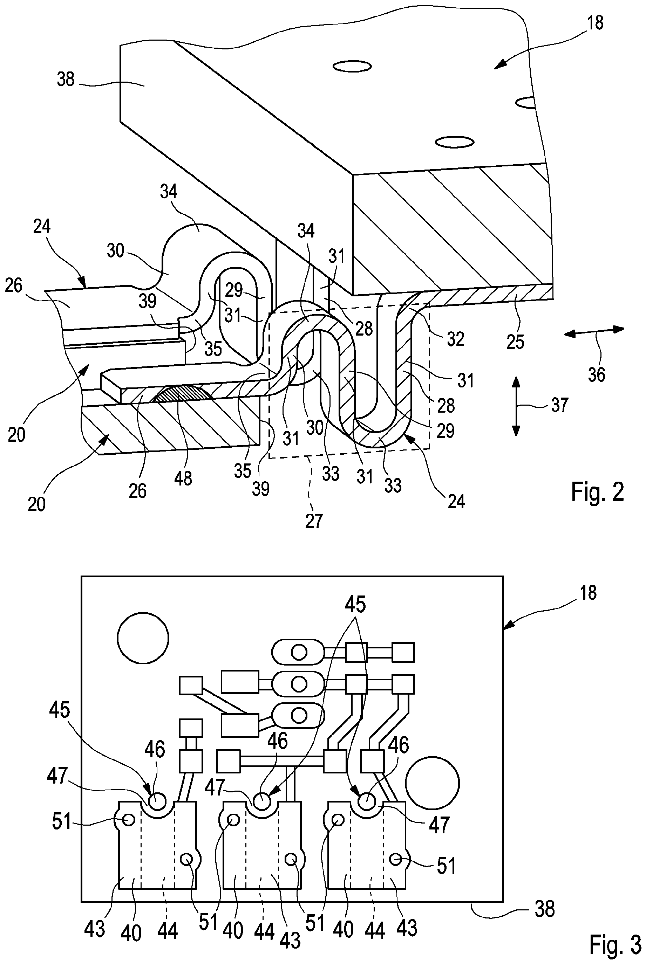

Die elektrische Kontaktierung zwischen der Platine 18 und der Metallstruktur 20 wird dabei mit wenigstens einem Kontaktelement 24 realisiert, das im Folgenden anhand von Figur 2 näher erläutert wird. Fig. 2 zeigt dabei zwei Kontaktelemente 24, nämlich im Vordergrund ein geschnittenes vorderes Kontaktelement 24 und im Hintergrund ein teilweise verdecktes hinteres Kontaktelement 24. Das jeweilige Kontaktelement 24, das aus einem elektrischen Leiter, vorzugsweise aus einem Metall, hergestellt ist, weist eine Platinenkontaktzone 25, die mit der Platine 18 elektrisch kontaktiert ist, und eine Metallstrukturkontaktzone 26 auf, die mit der Metallstruktur 20 elektrisch kontaktiert ist. Außerdem besitzt das Kontaktelement 24 zwischen den beiden Kontaktzonen 25, 26 eine wellenförmig gebogene Federzone 27, die in Figur 2 beim vorderen Kontaktelement 24 durch ein Rahmensymbol eingefasst ist. Die Federzone 27 verbindet die beiden Kontaktzonen 25, 26 miteinander und kann Relativbewegungen zwischen den beiden Kontaktzonen 25, 26 federelastisch aufnehmen.

Die Metallstruktur 20 ist ein elektrisch leitfähiges Bauteil, das gegebenenfalls beschichtet sein kann. An der Metallstruktur 20 kann optional eine hier nicht gezeigte Kontaktgeometrie, insbesondere eine Schweißgeometrie, vorgesehen sein, welche die jeweilige Kontaktfläche zwischen der Metallstruktur 20 und der damit verbundenen Metallstrukturkontaktzone 26 des jeweiligen Kontaktelements 24 reduziert, wodurch insbesondere eine punktförmige und auch punktgenaue Kontaktierung zwischen Kontaktelement 24 und Metallstruktur 20 erfolgen kann. Bevorzugt ist dabei eine Schweißverbindung bzw. ein Schweißpunkt, der in Fig. 2 mit 48 bezeichnet ist.

Bei der hier gezeigten, bevorzugten Ausführungsform des Kontaktelements 24 erstrecken sich die Platinenkontaktzone 25 und die Metallstrukturkontaktzone 26 jeweils geradlinig und parallel zueinander. Die Federzone 27 weist hier drei Quereabschnitte 28, 29, 30 auf, die sich jeweils quer zur Platinenkontaktzone 25 und quer zur Metallstrukturkontaktzone 26 erstrecken. Die einzelnen Querabschnitte 28, 29, 30 erstrecken sich im hier gezeigten Beispiel außerdem jeweils geradlinig sowie parallel zueinander. Die Formgebung der Federzone 27 ist hier ferner so gewählt, dass sie insgesamt drei Wendepunkte 31 enthält, die im Beispiel jeweils innerhalb eines der Querabschnitte 28, 29, 30 positioniert sind. Im Einzelnen besitzt die Federzone 27 hier einen ersten Querabschnitt 28, der über einen ersten L-förmigen Bogenabschnitt 32, der auch als erster L-Bogen 32 bezeichnet werden kann, in die Platinenkontaktzone 25 übergeht. Der erste Querabschnitt 28 geht außerdem distal zum ersten L-Bogen 32 über einen ersten U-förmigen Bogenabschnitt 33, der im Folgenden auch als erster U-Bogen 33 bezeichnet wird, in einen zweiten Querabschnitt 29 über. Der zweite Querabschnitt 29 geht distal zum ersten U-Bogen 33 über einen zweiten U-förmigen Bogenabschnitt 34, der im Folgenden auch als zweiter U-Bogen 34 bezeichnet wird, in einen dritten Querabschnitt 30 über. Der dritte Querabschnitt 30 geht distal zum zweiten U-Bogen 34 über einen zweiten L-förmigen Bogenabschnitt 35, der im Folgenden auch als zweiter L-Bogen 35 bezeichnet wird, in die Metallstrukturkontaktzone 26 über. Die beiden L-Bögen 32, 35 sind dabei jeweils als 90°-Bogen ausgestaltet. Die beiden U-Bögen 33, 34 sind dabei jeweils als 180°-Bogen ausgestaltet. Zweckmäßig besitzen die L-Bögen 32, 35 und die U-Bögen 33, 34 jeweils gleiche Biegeradien.

Das Kontaktelement 24 besitzt eine in Figur 2 durch einen Doppelpfeil angedeutete Längsrichtung 36, die durch die Abstandsrichtung der beiden Kontaktzonen 25, 26 definiert ist. Quer zu dieser Längsrichtung 36 besitzt das Kontaktelement 24 eine in Figur 2 durch einen Doppelpfeil angedeutete Querrichtung 37, die senkrecht auf den Ebenen steht, in denen die ebenen Kontaktzonen 25, 26 liegen. Bezüglich dieser Querrichtung 37 ist die Metallstrukturkontaktzone 26 zwischen dem ersten U-Bogen 33 und dem zweiten U-Bogen 34 positioniert. Ferner ist der zweite U-Bogen 34 bezüglich der Querrichtung 37 zwischen der Platinenkontaktzone 25 und der Metallstrukturkontaktzone 26 positioniert. Durch diese Positionierung kann sich die Platine 18 in der Längsrichtung 36 mit ihrem Rand 38 bis in den Bereich der Federzone 27 hineinerstrecken. Ferner können sich somit der erste Querabschnitt 28, der zweite Querabschnitt 29 und der erste U-Bogen 33 in der Querrichtung 37 über einen Rand 39 der Metallstruktur 20 hinauserstrecken.

Bevorzugt sind die Kontaktelemente 24 an ihren Metallstrukturkontaktzonen 26 mit der Metallstruktur 20 verschweißt. In Fig. 2 ist beim geschnittenen vorderen Kontaktelement 24 ein Schweißpunkt 48 erkennbar.

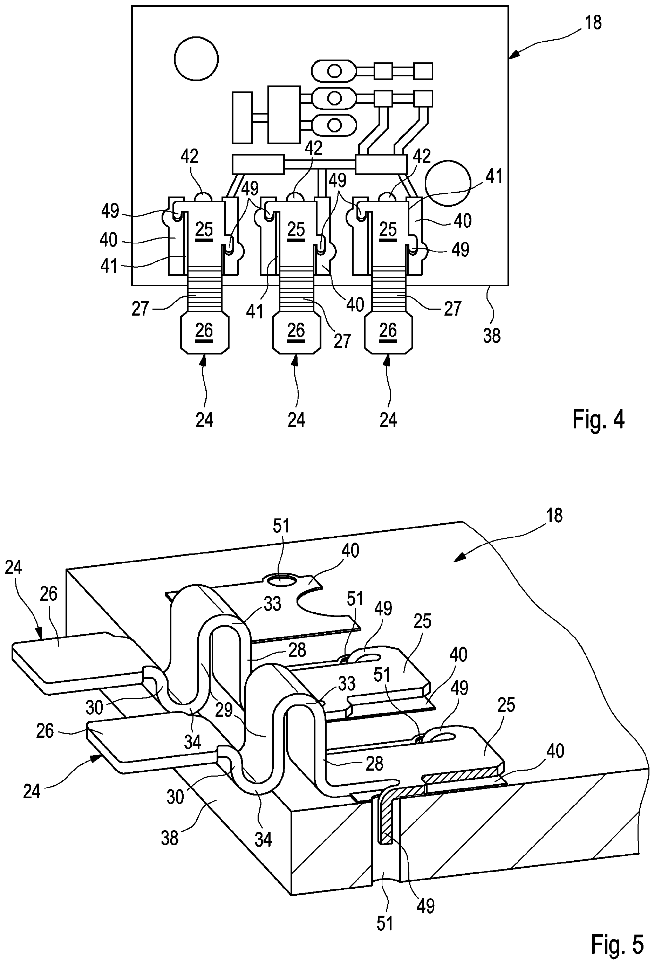

Gemäß den Figuren 3 und 4 besitzt die Platine 18 für das jeweilige Kontaktelement 24 jeweils eine Kontaktfläche 40, die für eine elektrische Kontaktierung mit dem jeweiligen Kontaktelement 24 vorgesehen ist. Im Beispiel der Figuren 3 und 4 sind dabei drei derartige Kontaktflächen 40 zum Anbringen von drei Kontaktelementen 24 vorgesehen. An diesen Kontaktflächen 40 tritt das jeweilige Kontaktelement 24 mit seiner Platinenkontaktzone 25 in Kontakt. Dabei ist das jeweilige Kontaktelement 24 im Bereich seiner Platinenkontaktzone 25 stoffschlüssig mit der zugehörigen Kontaktfläche 40 verbunden. Erreicht wird dies bevorzugt mittels einer Lötverbindung 41, die in Figur 4 erkennbar ist. Darüber hinaus ist für das jeweilige Kontaktelement 24 zusätzlich eine Klebverbindung 42 vorgesehen, um das Kontaktelement 24 in seiner Platinenkontaktzone 25 an der Platine 18 zu befestigen.

Wie insbesondere Figur 3 entnehmbar ist, ist die jeweilige Kontaktfläche 40 zweckmäßig durch eine elektrisch leitende, vorzugsweise metallische Beschichtung 43 realisiert, die auf geeignete Weise auf die Platine 18 aufgebracht ist, die ihrerseits üblicherweise aus einem elektrisch isolierenden Material, vorzugsweise ein Kunststoffmaterial, insbesondere FR4 oder ein Keramikmaterial, hergestellt ist.

Erkennbar ist dabei in der jeweiligen Kontaktfläche 40 randseitig in einem vom jeweiligen Kontaktelement 24 bzw. von dessen Platinenkontaktzone 25 abgedeckten, in Figur 3 durch unterbrochene Linien angedeuteten Kontaktbereich 44 jeweils eine Klebestelle 45 ausgespart, in der die jeweilige Klebverbindung 42 gemäß Figur 4 ausgebildet ist. Im Beispiel ist die jeweilige Klebestelle 45 insgesamt kreisförmig konzipiert, und am Rand des Kontaktbereichs 44 so angeordnet, dass sich innerhalb der jeweiligen Kontaktfläche 40 eine halbkreisförmige Aussparung ergibt. Die jeweilige Klebestelle 45 umfasst dabei eine kreisförmige, zentrale Klebstoffzone 46, in welcher der Klebstoff zum Herstellen der Klebverbindung 42 aufgebracht wird, sowie eine klebstofffreie, ringförmige, die Klebstoffzone 46 umschließende Abstandszone 47. Durch die Realisierung der klebstofffreien Abstandszone 47 kann ein unmittelbarer Kontakt zwischen dem Klebstoff und dem zum Herstellen der Lötverbindung vorgesehenen Kontaktbereich 44 innerhalb der Beschichtung 43 der Kontaktfläche 40 vermieden werden.

Das Herstellen dieser Platine 18 erfolgt zweckmäßig wie folgt. Vor dem Bestücken der Platine 18 mit den Kontaktelementen 24 werden die Kontaktflächen 40 mit einer Lotpaste bedruckt. Außerdem wird neben dem mit der Lotpaste bedruckten Lotbereich, der zumindest den Kontaktbereich 44 umfasst, ein Klebstoff unmittelbar auf die Platine 18 aufgebracht. Das Aufbringen des Klebstoffs erfolgt dabei zweckmäßig in der jeweiligen Klebstoffzone 46. Es spielt hierbei grundsätzlich keine Rolle, ob der Klebstoff vor oder nach dem Aufdrucken der Lotpaste aufgebracht wird. Mittels des Klebstoffs erfolgt eine Vorfixierung der Kontaktelemente 24 vor dem eigentlichen Verbindungs- bzw. Lötprozess.

Nachdem die Lotpaste und der Klebstoff auf die Platine 18 aufgebracht sind, erfolgt die Bestückung der Platine 18 mit den Kontaktelementen 24. Dabei wird das jeweilige Kontaktelement 24 so auf die Platine 18 aufgebracht, dass das Kontaktelement 24 mit seiner Platinenkontaktzone 25 den Lotbereich, also zumindest den Kontaktbereich 44 innerhalb der Kontaktfläche 40 flächig kontaktiert. Gleichzeitig kontaktiert das jeweilige Kontaktelement 24 in der Klebestelle 45 mit seiner Platinenkontaktzone 25 den Klebstoff, wodurch das jeweilige Kontaktelement 24 hinreichend fest mit der Platine 18 verbunden wird. Anschließend kann das jeweilige Kontaktelement 24 mit seiner Platinenkontaktzone 25 mit Hilfe der Lotpaste mit der Kontaktfläche 40 verlötet werden.

Gemäß Fig. 5 kann bei einer bevorzugten Ausführungsform das jeweilige Kontaktelement 24 in seiner Platinenkontaktzone 25 wenigstens einen Anker 49 aufweisen. Im gezeigten Beispiel sind je Kontaktelement 24 je zwei solche Anker 49 vorgesehen. Der jeweilige Anker 49 greift in ein Verankerungsloch 51 ein, das an der Platine 18, insbesondere in der Kontaktfläche 40, vorgesehen ist. Das jeweilige Verankerungsloch 51 kann ein Durchgangsloch sein. Der jeweilige Anker 49 kann integral am Kontaktelement 24 ausgeformt sein. Die Verankerungslöcher 51 sind auch in Fig. 3 erkennbar. Sofern die Anker 49 gemäß Fig. 4 so in der Kontaktfläche 40 positioniert sind, dass sie in die Lötverbindung 41 eingebunden sind, ergibt sich eine nochmals verbesserte Verankerung der Kontaktelemente 24 an der Platine 18. Die mit der Platine 18 verlöteten Anker 49 können auch als Lötanker 49 bezeichnet werden.

## Patentansprüche

1. Platine, insbesondere für eine Stellvorrichtung (1),
- wobei die Platine (18) wenigstens einen Positionssensor (19) trägt und wenigstens ein Kontaktelement (24) aufweist, das zwischen einer elektrisch mit der Platine (18) kontaktierten Platinenkontaktzone (25) und einer elektrisch mit einer Metallstruktur (20) kontaktierbaren Metallstrukturkontaktzone (26) eine gebogene Federzone (27) aufweist, die Relativbewegungen zwischen der Platinenkontaktzone (25) und der Metallstrukturkontaktzone (26) federelastisch aufnimmt,
- wobei die Federzone (27) einen ersten Querabschnitt (28) aufweist, der über einen ersten L-förmigen Bogenabschnitt (32) in die Platinenkontaktzone (25) übergeht und der über einen ersten U-förmigen Bogenabschnitt (33) in einen zweiten Querabschnitt (29) übergeht, der seinerseits über einen zweiten U-förmigen Bogenabschnitt (34) in einen dritten Querabschnitt (30) übergeht, der seinerseits über einen zweiten L-förmigen Bogenabschnitt (35) in die Metallstrukturkontaktzone (26) übergeht,
- wobei die Platinenkontaktzone (25) eben ist und in einer Ebene liegt,
- wobei die Metallstrukturkontaktzone (26) eben ist und in einer Ebene liegt,
- wobei eine Querrichtung (37) des Kontaktelements (24), die quer zu einer Längsrichtung (36) des Kontaktelements (24) verläuft, in der die Kontaktzonen (25, 26) voneinander beabstandet sind, senkrecht auf diesen Ebenen steht,
- und wobei die Metallstrukturkontaktzone (26) bezüglich der Querrichtung (37) des Kontaktelements (24) zwischen dem ersten U-Bogen (33) und dem zweiten U-Bogen (34) positioniert ist.

2. Platine nach Anspruch 1,
**dadurch gekennzeichnet,**
**dass** die Federzone (27) drei Wendepunkte (31) in ihrem gebogenen Verlauf enthält.

3. Platine nach Anspruch 1 oder 2,
**dadurch gekennzeichnet,**
**dass** der zweite U-Bogen (34) bezüglich der Querrichtung (37) des Kontaktelements (24) zwischen der Platinenkontaktzone (25) und der Metallstrukturkontaktzone (26) positioniert ist.

4. Platine nach einem der Ansprüche 1 bis 3,
**dadurch gekennzeichnet,**
**dass** sich die Querabschnitte (28, 29, 30) geradlinig und parallel zueinander erstrecken.

5. Platine nach einem der Ansprüche 1 bis 4,
**dadurch gekennzeichnet,**
- **dass** die Platine (18) für das jeweilige Kontaktelement (24) eine Kontaktfläche (40) zur elektrischen Kontaktierung mit dem Kontaktelement (24) aufweist,
- **dass** das jeweilige Kontaktelement (24) mit der zugehörigen Kontaktfläche (40) stoffschlüssig verbunden ist,
- **dass** das jeweilige Kontaktelement (24) zusätzlich mit einer Klebverbindung (42) an der Platine (18) befestigt ist.

6. Platine nach Anspruch 5,
**dadurch gekennzeichnet,**
**dass** in der jeweiligen Kontaktfläche (40) in einem vom jeweiligen Kontaktelement (24) abgedeckten Kontaktbereich (44) eine Klebestelle (45) ausgespart ist, in der die Klebverbindung (42) ausgebildet ist.

7. Platine nach Anspruch 6,
**dadurch gekennzeichnet,**
**dass** die jeweilige Klebestelle (45) eine mit dem Klebstoff versehene Klebstoffzone (46) und eine klebstofffreie Abstandszone (47) aufweist.

8. Platine nach einem der Ansprüche 1 bis 7,
**dadurch gekennzeichnet,**
**dass** das jeweilige Kontaktelement (24) in seiner Platinenkontaktzone (25) wenigstens einen Anker (49) aufweist, der in ein an der Platine (18) ausgebildetes Verankerungsloch (51) eingreift.

9. Platine nach Anspruch 8,
**dadurch gekennzeichnet,**
**dass** der jeweilige Anker (49) mit der Platine (18) verlötet ist.

10. Stellvorrichtung zum bidirektionalen Verstellen eines Stellglieds (2),
- mit einem Gehäuse (4) aus Kunststoff,
- mit einer Positionssensorik (15) zum Erfassen einer Position einer mobilen Komponente (16) der Stellvorrichtung (1) relativ zu einer stationären Komponente (17) der Stellvorrichtung (1),
- wobei die Positionssensorik (15) eine Platine (18) nach einem der vorhergehenden Ansprüche aufweist, die den wenigstens einen Positionssensor (19) trägt und die über das wenigstens eine Kontaktelement (24) mit einer zumindest teilweise in den Kunststoff des Gehäuses (4) eingebetteten Metallstruktur (20) elektrisch kontaktiert ist, indem die Metallstrukturkontaktzone (26) elektrisch mit der Metallstruktur (20) kontaktiert ist.

11. Stellvorrichtung nach Anspruch 10,
- mit einem am Gehäuse (4) angeordneten Stellantrieb (5) zum Erzeugen von Stell kräften,
- mit einer mit dem Stellantrieb (5) antriebsverbundenen und mit dem Stellglied (2) antriebsverbindbaren Kopplungseinrichtung (6) zum Übertragen der Stellkräfte vom Stellantrieb (5) auf das Stellglied (2).

12. Verfahren zum Herstellen einer Platine (18) nach einem der Ansprüche 1 bis 9,
- bei dem wenigstens eine Kontaktfläche (40), die zur elektrischen Kontaktierung mit einem Kontaktelement (24) vorgesehen ist, mit einer Lotpaste bedruckt wird,
- bei dem dann der mit der Lotpaste bedruckten Lotbereich wenigstens ein Klebstoff auf die Platine (18) aufgebracht wird,
- bei dem ein Kontaktelement (24) auf die Platine (18) aufgebracht wird, so dass das Kontaktelement (24) zum einen mit dem Lotbereich flächig kontaktiert ist und zum anderen mittels des Klebstoffs an der Platine (18) vorfixiert ist,
- bei dem das Kontaktelement (24) mit der Kontaktfläche (40) mittels der Lotpaste verlötet wird,
- wobei die Platine (18) wenigstens einen Positionssensor (19) trägt und das ein Kontaktelement (24) zwischen einer elektrisch mit der Platine (18) kontaktierten Platinenkontaktzone (25) und einer elektrisch mit einer Metallstruktur (20) kontaktierbaren Metallstrukturkontaktzone (26) eine gebogene Federzone (27) aufweist, die Relativbewegungen zwischen der Platinenkontaktzone (25) und der Metallstrukturkontaktzone (26) federelastisch aufnimmt,
- wobei die Federzone (27) einen ersten Querabschnitt (28) aufweist, der über einen ersten L-förmigen Bogenabschnitt (32) in die Platinenkontaktzone (25) übergeht und der über einen ersten U-förmigen Bogenabschnitt (33) in einen zweiten Querabschnitt (29) übergeht, der seinerseits über einen zweiten U-förmigen Bogenabschnitt (34) in einen dritten Querabschnitt (30) übergeht, der seinerseits über einen zweiten L-förmigen Bogenabschnitt (35) in die Metallstrukturkontaktzone (26) übergeht,
- wobei die Platinenkontaktzone (25) eben ist und in einer Ebene liegt,
- wobei die Metallstrukturkontaktzone (26) eben ist und in einer Ebene liegt,
- wobei eine Querrichtung (37) des Kontaktelements (24), die quer zu einer Längsrichtung (36) des Kontaktelements (24) verläuft, in der die Kontaktzonen (25, 26) voneinander beabstandet sind, senkrecht auf diesen Ebenen steht,
- und wobei die Metallstrukturkontaktzone (26) bezüglich der Querrichtung (37) des Kontaktelements (24) zwischen dem ersten U-Bogen (33) und dem zweiten U-Bogen (34) positioniert ist.

## Claims

1. Printed circuit board, in particular for a control device (1),
- wherein the printed circuit board (18) supports at least one position sensor (19) and has at least one contact element (24) which has, between a printed circuit board contact zone (25) electrically contacted with the circuit board (18) and a metal structure contact zone (26) electrically contactable with a metal structure (20), a curved spring zone (27) which resiliently accommodates the relative movements between the printed circuit board contact zone (25) and the metal structure contact zone (26),
- wherein the spring zone (27) has a first transverse portion (28) which transitions by way of a first L-shaped curved portion (32) into the printed circuit board contact zone (25) and which transitions by way of a first U-shaped curved portion (33) into a second transverse portion (29), which in turn transitions by way of a second U-shaped curved portion (34) into a third transverse portion (30), which in term transitions by way of a second L-shaped curved portion (35) into the metal structure contact zone (26),
- wherein the printed circuit board contact zone (25) is planar and lies in one plane,
- wherein the metal structure contact zone (26) is planar and lies in one plane,
- wherein a transverse direction (37) of the contact element (24), which runs transversely with respect to a longitudinal direction (36) of the contact element (24) in which the contact zones (25, 26) are spaced apart from one another, is perpendicular to these planes,
- and wherein the metal structure contact zone (26) is positioned with respect to the transverse direction (37) of the contact element (24) between the first Ushaped curve (33) and the second U-shaped curve (34).

2. Printed circuit board according to claim 1,
**characterised in**
**that** the spring zone (27) contains three turning points (31) in its curved configuration.

3. Printed circuit board according to claim 1 or 2,
**characterised in**
**that** the second U-shaped curve (34) with respect to the transverse direction (37) of the contact element (24) between the printed circuit board contact zone (25) and the second U-shaped curve (26).

4. Printed circuit board according to one of claims 1 to 3,
**characterised in**
**that** the transverse portions (28, 29, 30) extend in a straight line and parallel to one another.

5. Printed circuit board according to one of claims 1 to 4,
**characterised in**
- **that** the printed circuit board (18) for the respective contact element (24) has a contact area (40) for electrical contact with the contact element (24),
- **that** the respective contact element (24) is integrally bonded to the respective contact area (40),
- **that** the respective contact element (24) is additionally fastened by an adhesive bond (42) to the printed circuit board (18).

6. Printed circuit board according to claim 5,
**characterised in**
**that** in the respective contact area (40), in a contact region (44) covered by the respective contact element (24), an adhesion point (45) is cut out, in which the adhesive bond (42) is formed.

7. Printed circuit board according to claim 6,
**characterised in**
**that** the respective adhesion point (45) has an adhesive zone (46) provided with the adhesive and an adhesive-free spacing zone (47).

8. Printed circuit board according to one of claims 1 to 7,
**characterised in**
**that** the respective contact element (24) has, in its printed circuit board contact zone (25), at least one anchor (49) which engages in an anchoring hole (51) formed on the printed circuit board (18).

9. printed circuit board according to claim 8,
**characterised in**
**that** the respective anchor (49) is soldered to the printed circuit board (18).

10. Control device for bidirectional adjustment of an actuator (2),
- with a housing (4) made from plastic,
- with a position sensor (15) for detecting a position of a mobile component (16) of the control device (1) relative to a stationary component (17) of the control device (1),
- wherein the position sensor (15) has a printed circuit board (18) according to one of the preceding claims, which supports the at least one position sensor (19) and which by means of the at least one contact element (24) makes electrical contact with a metal structure (20) at least partially embedded in the plastic of the housing (4), as the metal structure contact zone (26) is electrically contacted by the metal structure (20).

11. Control device according to claim 10,
- with an actuating drive (5) arranged on the housing (4) for generating actuating forces,
- with a coupling device (6) which is connected for drive purposes to the actuating drive (5) and can be connected for drive purposes to the actuator (2) for transmitting the actuating forces from the actuating drive (5) to the actuator (2).

12. Method for producing a printed circuit board (18) according to one of claims 1 to 9,
- wherein at least one contact area (40) which is provided for electrical contact with a contact element (24), is imprinted with a soldering paste,
- wherein in the soldering region imprinted with the soldering paste at least one bonding adhesive is applied to the printed circuit board (18),
- wherein a contact element (24) is applied to the printed circuit board (18), so that the contact element (24) on the one hand is contacted flush with the soldering region and on the other hand is pre-fixed on the printed circuit board (18) by means of the bonding adhesive,
- wherein the contact element (24) is soldered to the contact area (40) by means of the soldering paste,
- wherein the printed circuit board (18) supports at least one position sensor (19) and has one contact element (24), between a printed circuit board contact zone (25) electrically contacted with the circuit board (18) and a metal structure contact zone (26) electrically contactable with a metal structure (20), a curved spring zone (27) which resiliently accommodates the relative movements between the printed circuit board contact zone (25) and the metal structure contact zone (26),
- wherein the spring zone (27) has a first transverse portion (28) which transitions by way of a first L-shaped curved portion (32) into the printed circuit board contact zone (25) and which transitions by way of a first U-shaped curved portion (33) into a second transverse portion (29), which in turn transitions by way of a second U-shaped curved portion (34) into a third transverse portion (30), which in term transitions by way of a second L-shaped curved portion (35) into the metal structure contact zone (26),
- wherein the printed circuit board contact zone (25) is planar and lies in one plane,
- wherein the metal structure contact zone (26) is planar and lies in one plane,
- wherein a transverse direction (37) of the contact element (24), which runs transversely with respect to a longitudinal direction (36) of the contact element (24) in which the contact zones (25, 26) are spaced apart from one another, is perpendicular to these planes,
- and wherein the metal structure contact zone (26) is positioned with respect to the transverse direction (37) of the contact element (24) between the first U-shaped curve (33) and the second U-shaped curve (34).

## Revendications

1. Carte, en particulier pour un dispositif de réglage (1),
- dans laquelle la carte (18) porte au moins un capteur de position (19) et comporte au moins un élément de contact (24) qui comporte, entre une zone de contact de carte (25) mise en contact électrique avec la carte (18) et une zone de contact de structure métallique (26) pouvant être mise en contact électrique avec une structure métallique (20), une zone pliée faisant ressort (27) qui absorbe élastiquement des mouvements relatifs entre la zone de contact de carte (25) et la zone de contact de structure métallique (26),
- dans laquelle la zone faisant ressort (27) comporte un premier tronçon transversal (28) qui se transforme via un premier tronçon d'arc en forme de L (32) en la zone de contact de carte (25) et qui se transforme via un premier tronçon d'arc en forme de U (33) en un deuxième tronçon transversal (29) qui se transforme lui-même via un deuxième tronçon en forme de U (34) en un troisième tronçon transversal (30) qui se transforme lui-même via un deuxième tronçon en forme de L(35) en la zone de contact de structure métallique (26),
- dans laquelle la zone de contact de carte (25) est plane et se trouve dans un plan,
- dans laquelle la zone de contact de structure métallique (26) est plane et se trouve dans un plan,
- dans laquelle une direction transversale (37) de l'élément de contact (24), direction qui s'étend transversalement par rapport à une direction longitudinale (36) de l'élément de contact (24) dans laquelle les zones de contact (25, 26) sont distantes l'une de l'autre, est perpendiculaire à ces plans
- et dans laquelle la zone de contact de structure métallique (26) est positionnée par rapport à la direction transversale (37) de l'élément de contact (24) entre le premier arc en U (33) et le deuxième arc en U (34).

2. Carte selon la revendication 1,
**caractérisée en ce**
**que** la zone faisant ressort (27) contient trois points d'inflexion (31) dans son étendue pliée.

3. Carte selon la revendication 1 ou 2,
**caractérisée en ce**
**que** le deuxième arc en U (34) est positionné par rapport à la direction transversale (37) de l'élément de contact (24) entre la zone de contact de carte (25) et la zone de contact de structure métallique (26).

4. Carte selon l'une quelconque des revendications 1 à 3,
**caractérisée en ce**
**que** les tronçons transversaux (28, 29, 30) s'étendent de manière rectiligne et parallèlement les uns aux autres.

5. Carte selon l'une quelconque des revendications 1 à 4,
**caractérisée en ce que**
- la carte (18) comporte pour l'élément de contact (24) respectif une surface de contact (40) destinée à la mise en contact électrique avec l'élément de contact (24),
- l'élément de contact (24) respectif est assemblé par liaison de matière à la surface de contact (40) associée,
- l'élément de contact (24) respectif est fixé en plus avec un assemblage collé (42) à la carte (18).

6. Carte selon la revendication 5,
**caractérisée en ce**
**que**, dans la surface de contact (40) respective, dans une zone de contact (44) recouverte par l'élément de contact (24) respectif, est réservé un point de collage (45) dans lequel est réalisé l'assemblage collé (42).

7. Carte selon la revendication 6,
**caractérisée en ce**
**que** le point de collage (45) respectif comporte une zone adhésive (46) munie de l'adhésif et une zone de mise à distance (47) sans adhésif.

8. Carte selon l'une quelconque des revendications 1 à 7,
**caractérisée en ce**
**que** l'élément de contact (24) respectif comporte dans sa zone de contact de carte (25) au moins un tirant (49) qui pénètre dans un trou d'ancrage (51) réalisé au niveau de la carte (18).

9. Carte selon la revendication 8,
**caractérisée en ce**
**que** le tirant (49) respectif est brasé avec la carte (18).

10. Dispositif de réglage destiné au déplacement bidirectionnel d'un organe de réglage (2),
- avec un corps (4) en plastique,
- avec un système capteur de position (15) destiné à détecter une position d'un composant mobile (16) du dispositif de réglage (1) par rapport à un composant stationnaire (17) du dispositif de réglage (1),
- dans lequel le système capteur de position (15) comporte une carte (18) selon l'une quelconque des revendications précédentes qui porte l'au moins un capteur de position (19) et qui, via l'au moins un élément de contact (24), est mis en contact électrique avec une structure métallique (20) noyée au moins partiellement dans le plastique du corps (4), la zone de contact de structure métallique (26) étant ainsi mise en contact électrique avec la structure métallique (20).

11. Dispositif de réglage selon la revendication 10,
- avec un dispositif d'entraînement de réglage (5) agencé au niveau du corps (4) et destiné à produire des forces de réglage,
- avec un dispositif de couplage (6) relié pour l'entraînement au dispositif d'entraînement de réglage (5) et pouvant être relié pour l'entraînement à l'organe de réglage (2) et destiné à transmettre les forces de réglage du dispositif d'entraînement de réglage (5) à l'organe de réglage (2).

12. Procédé de fabrication d'une carte (18) selon l'une quelconque des revendications 1 à 9,
- dans lequel au moins une surface de contact (40), qui est prévue pour la mise en contact électrique avec l'élément de contact (24), est imprimée avec une pâte décapante,
- dans lequel, à côté de la zone de brasage imprimée avec la pâte décapante, au moins un adhésif est ensuite appliqué sur la carte (18),
- dans lequel un élément de contact (24) est appliqué sur la carte (18) de telle sorte que l'élément de contact (24) d'une part est mis en contact par sa surface avec la zone de brasage et d'autre part est préalablement fixé au moyen de l'adhésif à la carte (18),
- dans lequel l'élément de contact (24) est brasé avec la surface de contact (40) au moyen de la pâte à braser,
- dans lequel la carte (18) porte au moins un capteur de position (19) et l'élément de contact (24) comporte, entre une zone de contact de carte (25) mise en contact électrique avec la carte (18) et une zone de contact de structure métallique (26) pouvant être mise en contact électrique avec une structure métallique (20), une zone pliée faisant ressort (27) qui absorbe élastiquement des mouvements relatifs entre la zone de contact de carte (25) et la zone de contact de structure métallique (26),
- dans laquelle la zone faisant ressort (27) comporte un premier tronçon transversal (28) qui se transforme via un premier tronçon d'arc en forme de L (32) en la zone de contact de carte (25) et qui se transforme via un premier tronçon d'arc en forme de U (33) en un deuxième tronçon transversal (29) qui se transforme lui-même via un deuxième tronçon en forme de U (34) en un troisième tronçon transversal (30) qui se transforme lui-même via un deuxième tronçon en forme de L(35) en la zone de contact de structure métallique (26),
- dans laquelle la zone de contact de carte (25) est plane et se trouve dans un plan,
- dans laquelle la zone de contact de structure métallique (26) est plane et se trouve dans un plan,
- dans laquelle une direction transversale (37) de l'élément de contact (24), direction qui s'étend transversalement par rapport à une direction longitudinale (36) de l'élément de contact (24) dans laquelle les zones de contact (25, 26) sont distantes l'une de l'autre, est perpendiculaire à ces plans
- et dans laquelle la zone de contact de structure métallique (26) est positionnée par rapport à la direction transversale (37) de l'élément de contact (24) entre le premier arc en U (33) et le deuxième arc en U (34).
